# EUROPEAN PATENT APPLICATION

(11) **EP 4 811 426 A1**
(43) Date of publication of application: **23.09.2026**
(21) Application number: 25164662.6
(22) Date of filing: 19.03.2025
(51) Int. Cl.: H01L 23/053, H01L 23/10, H01L 21/50

(54) **HOUSING STRUCTURE, POWER SEMICONDUCTOR MODULE, AND METHOD FOR PRODUCING A HOUSING STRUCTURE**

(71) Applicant: Hitachi Energy Ltd, 8050 Zürich (CH)
(72) Inventor: Truessel, Dominik, 5620 Bremgarten (CH); Santolaria, Lluis, 4600 Olten (CH)
(74) Representative: Epping - Hermann - Fischer

(57) **Abstract**

A housing structure (2) for a power semiconductor module (1) with at least one power semiconductor chip arranged on a mounting portion (6) is specified, comprising
- a bottom portion (4) configured to surround the at least one power semiconductor chip arranged on the mounting portion (6) in lateral directions, and
- a top portion (3) arranged on the bottom portion (4), wherein
- the top portion (3) comprises at least one anchoring element (12) comprising
- at least one shaft (13) having a main extension direction in a vertical direction, and
- at least one anchoring structure (14) having a main extension direction in lateral directions arranged at the at least one shaft (13),

- the bottom portion (4) comprises at least one recess (16),
- the at least one shaft (13) is arranged at least partially, and the at least one anchoring structure (14) is arranged completely, in the at least one recess (16), and
- a potting material (17) is at least partially arranged in the at least one recess (16).

Furthermore, a power semiconductor module (1) and a method for producing a housing structure (2) are specified.

## Description

The present disclosure relates to a housing structure, a power semiconductor module, and a method for producing a housing structure.

Typically, the use of standard fixation methods between joining partners like screwed connections or snap-fit connections may provide some disadvantages in typical housing structures for typical power semiconductor modules, particularly molded power packages. Exemplarily, screwed connections need corresponding thread inserts to be integrated in a molded body, which makes the setup of a corresponding molding tool and the molding process complex and expensive. For example, snap-fit connections typically do not provide sufficient mechanical stability during mechanical shocks and vibrations.

Embodiments of the disclosure relate to a housing structure which is particularly reliable and simple in manufacturing. Further embodiments relate to a power semiconductor module, and to a method for producing such a housing structure.

This is achieved by the subject-matter of the independent claims. Further embodiments are evident from the dependent claims and the following description.

A housing structure for a power semiconductor module with at least one power semiconductor chip arranged on a mounting portion is described. The term "power" here and in the following refers, for example, to power semiconductor modules and/or power semiconductor chips adapted for processing voltages and currents of more than 100 V and/or more than 10 A, respectively, exemplarily voltages of up to 10 kV and electrical currents of up to 10 kA.

The power semiconductor chip comprises, for example, a semiconductor material such as at least one of silicon (Si), silicon carbide (SiC), and gallium nitride (GaN). The power semiconductor chip is, for example, a power diode and/or a power metal insulating semiconductor field-effect transistor, power MISFET for short. The term MISFET shall also include MOSFETs, which have an oxide as an insulating material at a gate. The power semiconductor chip may also be an insulated-gate bipolar transistor, IGBT, or a high electron mobility transistor, HEMT.

The mounting portion is, for example, part of a carrier, a lead frame, a die pad, a baseplate, an insulated metal substrate or a ceramic-based substrate of the power device. The mounting portion has, for example, a main extension plane. The main extension plane extends particularly in lateral directions. A vertical direction is oriented perpendicular to the lateral directions. Exemplarily, the power semiconductor chip has a main extension plane parallel to the lateral directions. The power semiconductor chip and the mounting portion are stacked above one another along a stacking direction being the vertical direction.

According to an embodiment, the housing structure comprises a bottom portion configured to surround the at least one power semiconductor chip arranged on the mounting portion in lateral directions. Exemplarily, the bottom portion completely surrounds the at least one power semiconductor chip and the mounting portion in lateral directions. For example, the bottom portion defines a housing cavity in which the power semiconductor chip is, particularly completely, arranged. The bottom portion has, for example, at least one inner side surface delimiting a part of the housing cavity. In particular, the at least one inner side surface of the bottom portion faces the power semiconductor chip in lateral directions. Exemplarily, the at least one inner side surface extends at least regionally transverse to the lateral directions, e.g. in a vertical direction. The bottom portion forms, for example, a side wall of the housing structure.

For example, the power semiconductor chip has a top surface and a bottom surface arranged opposite the top surface, wherein the top surface and the bottom surface extend in lateral directions. The top surface and the bottom surface of the power semiconductor chip are connected by at least one side surface, extending transverse to the lateral directions, e.g. in a vertical direction. The at least one side surface of the power semiconductor chip is particularly arranged opposite the at least one inner side surface.

For example, the mounting portion has a top surface and a bottom surface arranged opposite the top surface, wherein the top surface and the bottom surface extend in lateral directions. The power semiconductor chip is arranged with its bottom surface on the top surface of the mounting portion. The top surface and the bottom surface of the mounting portion are connected by at least one side surface, extending transverse to the lateral directions, e.g. in a vertical direction. The at least one side surface of the mounting portion is particularly arranged opposite the at least one inner side surface.

The bottom portion comprises or consists of a first material, which comprises or consists of a mold material. The mold material can comprise a thermosetting resin, such as an epoxy resin, or a thermoplastic material, and in particular a filler material, exemplary being particles or fibers, e.g. silica, and/or a hardening agent. Exemplarily, the bottom portion is produced by a transfer molding process or an injection molding process.

The bottom portion is, for example, in direct contact with the power semiconductor chip and/or the mounting portion. Alternatively, there is a gap between the bottom portion and the power semiconductor chip and/or the mounting portion. Exemplarily, the gap is filled with a further first material different from the first material of the bottom portion. The further first material can be at least one of a potting resin and a gel. The further first material is, in particular, in direct contact with the power semiconductor chip and/or the mounting portion.

According to the embodiment, the housing structure comprises a top portion arranged on the bottom portion. Exemplarily, the top portion is in direct contact with the bottom portion. For example, the top portion completely overlaps with the power semiconductor chip, and exemplarily at least partly with the mounting portion, in lateral directions, in particular in a plan view directed in the vertical direction. The top portion has, for example, a main extension plane. The main extension plane of the top portion extends particularly in lateral directions. For example, the main extension planes of the top portion and the mounting portion are parallel to one another. Exemplarily, the top portion protrudes beyond the mounting portion in lateral directions.

For example, the bottom portion and the top portion, and exemplarily the mounting portion, define the housing cavity in which the power semiconductor chip is, particularly completely, arranged. The top portion has, for example, a bottom surface delimiting a part of the housing cavity. In particular, the bottom surface of the top portion faces the power semiconductor chip. The bottom portion forms, for example, a cover wall of the housing structure.

Exemplarily, there is a further gap between the top portion and the power semiconductor chip and the mounting portion. Exemplarily, the further gap is at least partly filled with the further first material.

For example, the power semiconductor chip is completely enclosed by the top portion and the bottom portion and in particular the mounting portion. Exemplarily, a peripheral region of the top portion, in particular of the bottom surface of the top portion in the peripheral region, is connected to the bottom portion. The peripheral region particularly does not overlap with the power semiconductor chip in lateral directions in plan view along the vertical direction. A central region of the top portion completely surrounded by the peripheral region of the top portion in lateral directions particularly at least partly overlap with the power semiconductor chip in lateral directions in plan view along the vertical direction.

In particular, the top portion and the bottom portion form a protective enclosure and/or provide mechanical support for the power semiconductor chip and protection against the environment, particularly for the power semiconductor chip and the mounting portion.

According to the embodiment of the housing structure, the top portion comprises at least one anchoring element, in particular in the peripheral region. The anchoring element is, for example, configured to attach the bottom portion to the top portion in a mechanically stable manner. In particular, the anchoring element is a part of the top portion for providing the mechanically stable attachment to the bottom portion.

According to the embodiment of the housing structure, the at least one anchoring element comprises at least one shaft having a main extension direction in a vertical direction. For example, the at least one shaft protrudes in the vertical direction beyond the bottom surface of the top portion in the direction towards the bottom portion.

According to the embodiment of the housing structure, the at least one anchoring element comprises at least one anchoring structure having a main extension direction in lateral directions, wherein the at least one anchoring structure is arranged at the at least one shaft. For example, the anchoring structure is formed integrally with the shaft. The anchoring structure protrudes, for example, in lateral directions beyond at least one side surface of the shaft extending in the vertical direction. For example, the anchoring structure is arranged at an end region of the shaft. Exemplarily, in plan view, the anchoring element does not overlap in plan view with the power semiconductor chip in lateral directions.

In particular, a cross section of the shaft and the anchoring structure in one lateral direction and in the vertical direction has a T-shape structure or an L-shape structure.

According to the embodiment of the housing structure, the bottom portion comprises at least one recess. For example, the recess partially penetrates the bottom portion from a top surface of the bottom portion towards a bottom surface of the bottom portion. The top surface of the bottom portion particularly faces the top portion. The recess extends, for example, into the bottom portion down to a predefined depth in the vertical direction. The predefined depth is, in particular, smaller than a thickness in the vertical direction of the bottom portion.

Exemplarily, at least one side surface of the recess and a bottom surface of the recess are delimited by the bottom portion. For example, the recess tapers in the direction towards the bottom surface. The recess has a cross section in lateral directions being circular, elliptical, or polygonal, such as quadrangular or rectangular.

According to the embodiment of the housing structure, the at least one shaft is arranged at least partially, and the at least one anchoring structure is arranged completely, in the at least one recess. In particular, the anchoring element extends into the recess, wherein the anchoring structure is arranged completely in the recess. For example, the anchoring structure has a maximal extent along the main extension direction in lateral directions that is smaller than a cross section in lateral directions of the recess.

According to the embodiment of the housing structure, a potting material is at least partially arranged in the at least one recess. For example, the potting material is configured to fix the anchoring element, particularly the shaft and the anchoring structure, in the recess in a mechanically stable manner, in order to attach the bottom portion to the top portion in a mechanically stable manner. Exemplarily, the anchoring structure is embedded in the potting material. "Embedded" means that the outer surface of the anchoring structure that is not in contact with the shaft is completely covered by and/or directly connected to the potting material.

"Fix in a mechanically stable manner" and/or "attach in a mechanically stable manner" means here and in the following that a separation of the top portion and the bottom portion is not possible under normal conditions without damaging at least one of the portions.

It is possible that the one top portion can be arranged on multiple bottom portions, each bottom portion being configured to surround at least one power semiconductor chip arranged on a respective mounting portion. Exemplarily, the top portion can have anchoring elements also in the central region for connection the bottom portions and not only in the peripheral region.

Advantageously, with such a housing structure, the top portion and the bottom portion used for housing the power semiconductor chip are advantageously attached to one another in a mechanically stable manner. The described attachment via the anchoring element and the corresponding recess is particularly easy and thus cost saving. Furthermore, the attachment process using such an anchoring element is particularly simple, thus saving processing resources. Exemplarily, snap-fit connections are difficult or impossible to realize in epoxy molding tools, and thus the present anchoring solution is advantageously beneficial.

For example, the housing structure does not comprise any screwed connections and/or snap-fit connections for attachment of the top portion to the bottom portion. In fact, the anchoring element is advantageously configured to provide sufficient mechanical stability during mechanical shocks and/or vibrations. Furthermore, compared to screwed and/or snap-fit connections, the anchoring element is advantageously less complex and expensive.

According to a further embodiment of the housing structure, the at least one recess partially penetrates the bottom portion in the vertical direction. This means that the recess extends into the bottom portion down to the predefined depth in the vertical direction, wherein the recess is delimited by the bottom portion. For example, the recess does not protrude beyond the mounting portion in the vertical direction.

The bottom portion can comprise a plurality of recesses. For example, the recesses are all arranged in the peripheral region. In particular, the recesses are all spaced apart from one another in lateral directions.

According to a further embodiment of the housing structure, the at least one anchoring element comprises a top main portion having a main extension direction in lateral directions. For example, the top main portion has an extent in lateral directions that is equal to or larger than the cross section of the recess in lateral directions.

According to a further embodiment of the housing structure, the at least one shaft is arranged on the top main portion. In particular, the top main portion and the shaft are attached to one another in a mechanically stable manner. For example, the top main portion is formed integrally with the shaft.

According to a further embodiment of the housing structure, the top main portion has at least one opening. The at least one opening can have a round shape, an elliptic shape or a polygonal shape, such as a square shape or a rectangular shape, in a cross section in lateral directions.

The opening of the top main portion can comprise at least two sub-openings, wherein the at least two sub-openings are formed mirror-symmetric for forming the opening. Exemplarily, the two sub-openings are spaced apart from one another, particularly by the shaft, and are in particular not connected in a simple manner. For example, the two sub-openings are spaced apart from one another by a shaft, wherein the shaft is part of the top main portion. A mirror plane for the two openings extends, for example, in the vertical direction along a main extension direction of the shaft. For example, each of the sub-openings are formed of a segment of the opening. In particular, if the opening has the cross-sectional shape as described above, each of the sub-openings has a corresponding cross section, being a segment of the cross section of the opening, extending regionally along the corresponding shape of the opening.

According to a further embodiment of the housing structure, the opening completely penetrates the top main portion in the vertical direction. In particular, each of the sub-openings completely penetrates the top main portion in the vertical direction.

Advantageously, the potting material can be inserted in the recess through the opening.

According to a further embodiment of the housing structure, the potting material is completely arranged in the at least one recess. For example, the potting material extends from the bottom surface of the recess up to the top surface of the bottom portion. Exemplarily, the potting material terminates flush with the top surface of the bottom portion. Alternatively, the potting material protrudes beyond the top surface of the bottom portion in the direction towards the top portion. For example, if the potting material protrudes beyond the top surface of the bottom portion, the potting material is additionally at least partially arranged in the opening.

Exemplarily, if the potting material protrudes beyond the top surface of the bottom portion in the direction towards the top portion, an intermediate element, such as a seal or a spacer, is arranged between the top portion and the bottom portion. In particular, the intermediate element is an integral part of the top portion and arranged between the opening and the recess, wherein the intermediate element has an inner extension being equal to or larger than an extension of the recess and an extension of the opening in lateral directions. Exemplarily, the intermediate element delimits a further opening, for connecting the opening to the recess.

According to a further embodiment of the housing structure, the potting material is at least partially arranged in the opening. For example, the potting material extends from the bottom surface of the recess up to a predetermined height that is smaller than a height of the recess in the vertical direction.

According to a further embodiment of the housing structure, a cross-sectional shape in lateral directions of the at least one shaft is round, elliptic, or polygonal. The cross-sectional shape of the shaft is, for example, a round shape, an elliptic shape or a polygonal shape, such as a square shape or a rectangular shape.

According to a further embodiment of the housing structure, a cross-sectional shape in lateral directions of the at least one anchoring structure is round, elliptic, or polygonal. The cross-sectional shape of the anchoring structure is, for example, a round shape, an elliptic shape or a polygonal shape, such as a square shape or a rectangular shape. Exemplarily, the cross-sectional shape of the anchoring structure and the cross-sectional shape of the shaft can be the same or different from one another.

According to a further embodiment of the housing structure, the potting material comprises or consists of a glue and/or a resin. Exemplarily, the potting material is different from or equal to the first material and/or the further first material.

According to a further embodiment of the housing structure, the top portion comprises a further top main portion. The top main portion has, for example, a bottom surface and a top surface, and the further top main portion has, for example, a bottom surface and a top surface. The top surfaces of the top main portion and the further top main portion extend, in particular, in a common main extension plane, exemplarily forming the top surface of the top portion. The bottom surfaces of the top main portion and the further top main portion extend, in particular, in a common main extension plane, exemplarily forming the bottom surface of the top portion. Exemplarily, the top main portion is embedded in the further top main portion.

For example, the top main portion is arranged in the peripheral region not overlapping in lateral directions with the power semiconductor chip in plan view. Exemplarily, the further top main portion is arranged in the peripheral region not overlapping in lateral directions with the power semiconductor chip in plan view, and in the central region overlapping in lateral directions with the power semiconductor chip in plan view.

According to a further embodiment of the housing structure, the top main portion of the at least one anchoring element and the further top main portion are connected in a mechanically stable manner. For example, the top main portion is formed integrally with the further top main portion or is connected thereto with a mechanically stable connection.

According to a further embodiment of the housing structure, the bottom portion is a frame or a molded package. Preferably, the bottom portion is a molded package.

According to a further embodiment of the housing structure, the top portion is a cover or a terminal assembly, particularly an auxiliary terminal assembly.

According to a further embodiment of the housing structure, the terminal assembly comprises at least one terminal having a main extension direction in the vertical direction. Exemplarily, the terminal is an auxiliary terminal or a power terminal. For example, the terminal is electrically conductively connected to the power semiconductor chip and/or the mounting portion.

The auxiliary terminal assembly comprises, for example, a terminal connection structure extending in lateral directions, wherein the terminal connection structure can comprise the further top main portion or at least a part of the terminal connection structure. The terminal is arranged at the terminal connection structure extending in the vertical direction. Exemplarily, the terminal connection structure corresponds to the further top main portion. Exemplarily, the terminal connection structure can be a further part or at least a part of the further top main portion having a different shape.

A further embodiment relates to a power semiconductor module, in particular comprising a housing structure as described herein above. Therefore, the features as described in connection with the power semiconductor module are also applicable to the housing structure and vice versa.

According to an embodiment, the power semiconductor module comprises at least one mounting portion, and at least one power semiconductor chip arranged on the mounting portion.

According to the embodiment, the power semiconductor module comprises the housing structure as described herein above.

According to the embodiment of the power semiconductor module, the housing structure and the mounting portion enclose the at least one power semiconductor chip. In particular, the power semiconductor chip is completely surrounded by the housing structure and the mounting portion in a three-dimensional manner, except possible further connections for electrically conductively connecting the power semiconductor chip and/or the mounting portion.

A further embodiment relates to a method for producing a housing structure, in particular a housing structure as described herein above. Therefore, the features as described in connection with the method are also applicable to the housing structure and vice versa.

According to an embodiment of the method, a bottom portion is provided, the bottom portion being configured to surround at least one power semiconductor chip arranged on a mounting portion in lateral directions, wherein the bottom portion comprises at least one recess.

According to an embodiment of the method, a top portion is provided, the top portion comprising at least one anchoring element, wherein the anchoring element comprises at least one shaft having a main extension direction in a vertical direction, and at least one anchoring structure having a main extension direction in lateral directions and being arranged at the at least one shaft.

According to an embodiment of the method, the top portion is arranged on the bottom portion such that the at least one shaft is arranged at least partially, and the at least one anchoring structure is arranged completely, in the at least one recess.

According to an embodiment of the method, a potting material is at least partially arranged in the at least one recess.

According to an embodiment of the method, the potting material is filled in the at least one recess before the top portion is arranged on the bottom portion.

According to an embodiment of the method, the potting material is filled in the at least one recess through at least one opening of a top main portion of the at least one anchoring element after the top portion is arranged on the bottom portion.

The opening is advantageously used for producing the top portion, e.g. the plastic part thereof, by an injection molding process, because it is possible to use simple injection molding tools without sliding/moveable tool parts in lateral directions. Without an opening, the anchoring structure needs to be produced in a tool with moveable parts in lateral directions, which would increase tool complexity, e.g. leading to higher costs, and would limit the options of positioning the anchoring elements, due to a limited access of movable parts in the tool.

The housing structure and/or the method for producing the housing structure are also applicable if the top portion is configured to be the frame or the molded package and the bottom portion is configured to be the mounting portion.

The accompanying Figures are included to provide a further understanding. It is to be understood that the embodiments shown in the Figures are illustrative representations and are not necessarily drawn to scale.
Figures 1 to 3 each show a schematic view of a housing structure for a power semiconductor module according to an exemplary embodiment.
Figures 4 and 5 each show a schematic view of an anchoring element of the housing structure according to an exemplary embodiment.
Figures 6, 7 and 8 as well as Figure 9 each show a method stage of a method for producing the housing structure according to an exemplary embodiment.
Figures 10 to 18 each show a schematic view of an anchoring element of the housing structure according to an exemplary embodiment.
Figures 19 to 25 each show a schematic view of an anchoring element of the housing structure according to an exemplary embodiment.

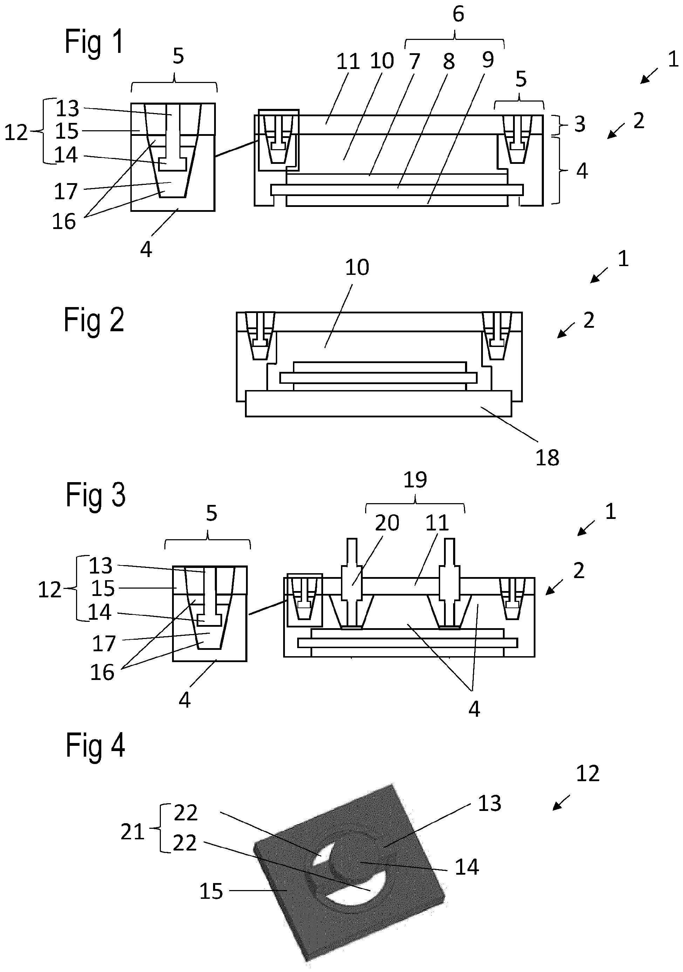

According to the exemplary embodiment of Figure 1, the housing structure 2 for a power semiconductor module 1 with at least one power semiconductor chip arranged on a mounting portion 6 comprises a bottom portion 4 and a top portion 3. The bottom portion 4 surrounds the at least one power semiconductor chip in lateral directions, which is not shown in Figure 1. The power semiconductor chip is particularly arranged on the mounting portion 6. The bottom portion 4 surrounds the mounting portion 6 in lateral directions, and the power semiconductor chip is arranged on the mounting portion 6.

The mounting portion 6 can comprise a bottom metallization 9, an insulating sheet 8 and a top metallization 7, wherein the power semiconductor chip is arranged on a part of the top metallization 7. The bottom portion 4 is attached to the mounting portion 6 in a mechanically stable manner. In particular, the bottom portion 4 is directly arranged on the mounting portion 6 in places.

The top portion 3 is arranged on the bottom portion 4. The bottom portion 4 and the top portion 3, and in particular the mounting portion 6, define a housing cavity 10 in which the power semiconductor chip is, particularly completely, arranged. The top portion 3 is in direct contact with the bottom portion 4 in a peripheral region 5 of the housing structure 2.

The top portion 3 comprises at least one anchoring element 12 in the peripheral region 5, wherein two anchoring elements 12 are shown in Figure 1, arranged in opposite peripheral regions 5. In the peripheral region 5, the bottom portion 4 comprises at least one recess 16, wherein two recesses 16 are shown in Figure 1, arranged in the opposite peripheral regions 5. Each anchoring element 12 is arranged at least partly in a corresponding recess 16 in the bottom portion 4. One of the anchoring elements 12 is shown in an enlarged scale as an inset. The anchoring elements 12 protrude towards the bottom portion 4, and locations of anchoring elements 12 correspond with locations of the recesses 16.

The anchoring element 12 comprises a shaft 13 and an anchoring structure 14, wherein the anchoring structure 14 is arranged at the shaft 13. The shaft 13 has a main extension direction in a vertical direction, and the anchoring structure 14 has a main extension direction in lateral directions. The anchoring structure 14 has a maximal extension in at least one lateral direction that is larger than a maximal extension of the shaft 13 in the same lateral direction. This means that the anchoring structure 14 protrudes beyond the maximal extension in at least one lateral direction, or all lateral directions, of the shaft 13.

The anchoring element 12 further comprises a top main portion 15 extending in lateral directions. The shaft 13 is connected to the top main portion 15, which is connected to a further top main portion 11 of the top portion 3. In particular, the top main portion 15 and the further top main portion 11 are exemplarily formed integrally in order to form a common cover of the housing structure 2.

A bottom part of the shaft 13 is arranged in the recess 16, wherein the anchoring structure 14 is arranged at the bottom part. The anchoring structure 14 is arranged completely in the recess 16. Further, a potting material 17 is arranged in the recess 16. Particularly, the anchoring structure 14 is embedded in the potting material 17. This means that the anchoring structure 14, particularly an outer surface thereof that is not covered by the shaft 13, e.g. being in contact with the shaft 13, is completely covered by the potting material 17. The potting material 17 fixes the anchoring element 12 to the recess 16 in a mechanically stable manner - in order to attach the bottom portion 4 to the top portion 3 in a mechanically stable manner.

The housing structure 2 according to Figure 2 is spaced apart from the mounting portion 6 in contrast to Figure 1. Further, the mounting portion 6 is arranged on a cooler or a baseplate 18. The mounting portion 6 is arranged on the cooler or the baseplate 18. The bottom portion 4 and the top portion 3, and in particular the cooler or the baseplate 18 define the housing cavity 10 in which the power semiconductor chip and the mounting portion 6 are, particularly completely, arranged.

Exemplarily, the housing cavity 10 is filled with a gel or resin when the top portion 3 forming a housing cover is fixed to the bottom portion 4 forming a housing frame. Exemplarily, the filling is performed before or after the fixing the top portion 3 on the bottom portion 4. Here, for example, the housing cover has one or more anchoring elements 12 on its bottom surface in regions where the housing cover is mechanically connected with the housing frame, particularly in the peripheral region 5. Consequently, the housing frame has recesses 16 on corresponding positions for the reception of the anchoring elements 12 and to be filled with potting material 17 such as a glue or a resin. Depending on the assembly process, recesses 16 may be available on the housing cover, and anchoring elements 12 may be available on the top surface of the housing frame. This is used in a situation, when the joining is done in a process, where the module is turned by 180° due to process reasons.

It is also conceivable that the anchoring elements 12 can be used for the fixation between the mounting portion, being a baseplate or a substrate, and a housing frame.

The top portion 3 of the housing structure 2 according to Figure 3 is formed of a terminal assembly 19, in contrast to Figures 1 and 2. The terminal assembly 19 comprises a terminal connection structure having a main extension plane extending in lateral directions and a terminal 20 extending in the vertical direction. When the terminal assembly 19 is the top portion 3, then it exemplarily includes also the anchoring elements 12. The terminal is connected to the terminal connection structure. Particularly, the terminal connection structure corresponds to the further top main portion 11.

Each terminal 20 is configured to be electrically conductively connected to the mounting portion 6 and/or to the power semiconductor chip.

The housing structure 2 according to Figure 3 is advantageously dedicated to the fixation of the terminal assembly 19 to vertically arranged terminals 20, being e.g. pin terminals, where the anchoring elements 12 provide an improved strength of the connection between the terminal assembly 19 and the bottom portion 4, which is e.g. a molded body, such as a molded package body, whereas the bottom portion in Figures 1 and 2 is a frame. The anchoring elements 12 can be provided for a single terminal assembly 19 for a single bottom portion 4, but also for a common terminal assembly 19 for two or more bottom portions 4.

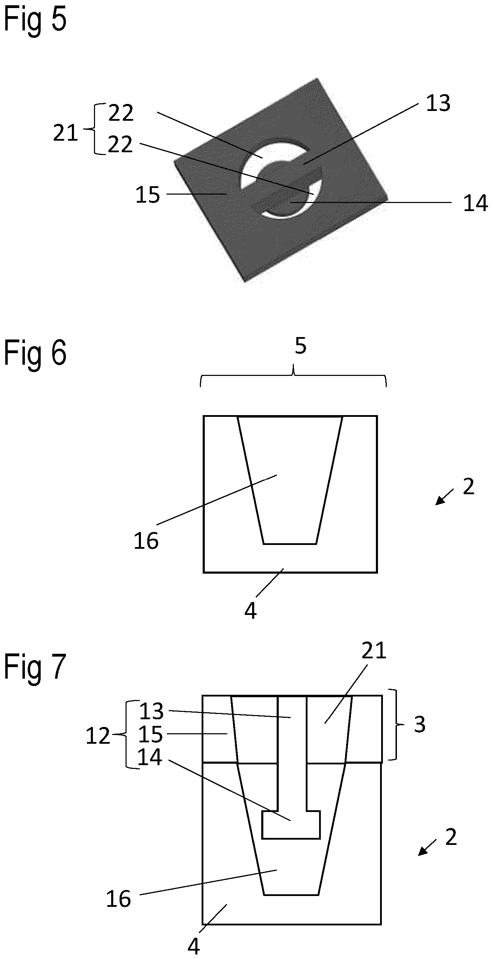

Advantageously, recesses 16 are provided in the bottom portion 4, and corresponding anchoring elements 12 are provided on the top portion 3, e.g. on a plastic part of the terminal assembly 19, like the terminal connection structure, e.g. comprising a control board structure, such as a printed circuit board, and/or a terminal block structure. The anchoring elements 12 are vertically arranged protruding parts facing downwards from the bottom surface of the plastic part of the terminal assembly 19. The anchoring elements 12 may have further integral structures for an improved anchoring - particularly the shaft 13 and the anchoring structure 14. By placing the terminal assembly 19 on top of the bottom portion 4, e.g. the molded body, the anchoring elements 12 are placed in the recesses 16. Subsequently, the recesses 16 in the molded body are filled with the potting material 17, e.g. through openings 21 in the anchoring elements 12, as explicitly indicated in Figures 4 and 5. After hardening of the potting material 17, the anchoring elements 12 can hold the terminal assembly 19 in place and provide mechanical strength for safe attachment and to maintain the electrical connection to the power semiconductor module 1 and/or to the printed circuit board even during shock and vibrations. The terminal assembly 19 can also be on modules with frame and cover as shown in Figures 1 and 2.

In addition, the anchoring elements 12 can also be used advantageously for the alignment of the top portion 3 to the bottom portion 4, in vertical direction and/or lateral directions.

The anchoring element 12 according to Figure 4 illustrates a view towards the bottom surfaces. The top main portion 15 comprises an opening 21 completely penetrating the top main portion 15 in the vertical direction. Further, the opening 21 of the top main portion 15 comprises two sub-openings 22, wherein the two sub-openings 22 are formed mirror symmetric with respect to the shaft 13. The two sub-openings 22 are in particular spaced apart from one another by the shaft 13.

A cross-sectional shape in lateral directions of the shaft 13 is polygonal, in particular has a rectangular shape. The rectangular shape has a main extension direction in lateral directions. A cross-sectional shape in lateral directions of the anchoring structure 14 is round, in particular has a round shape. The anchoring structure 14 protrudes at least partly beyond the shaft 13 in lateral directions in plan view in a direction perpendicular to the main extension direction of the rectangular shape.

The anchoring element 12 according to Figure 5 illustrates a view towards the top surfaces, opposite the bottom surface in Figure 4. In particular, the opening 21 is divided into the two sub-openings 22 by the shaft, which corresponds to the top part of the shaft 13. In particular, the shaft is part of the top main portion 15, in particular part of the anchoring element 12.

In a cross section, the opening 21 has a round shape in lateral directions, and thus each of the sub-openings 22 has a corresponding cross section extending regionally along the corresponding round shape of the opening 21. In particular, each sub-opening 22 is formed of a circular segment of the opening 21.

In a method stage according to Figure 6 for producing the housing structure 2 according to one of Figures 1 to 3, the bottom portion 4 with the recess 16 is provided.

Subsequently, in a method stage according to Figure 7, the top portion 3 comprising the anchoring element 12 is arranged on the bottom portion 4.

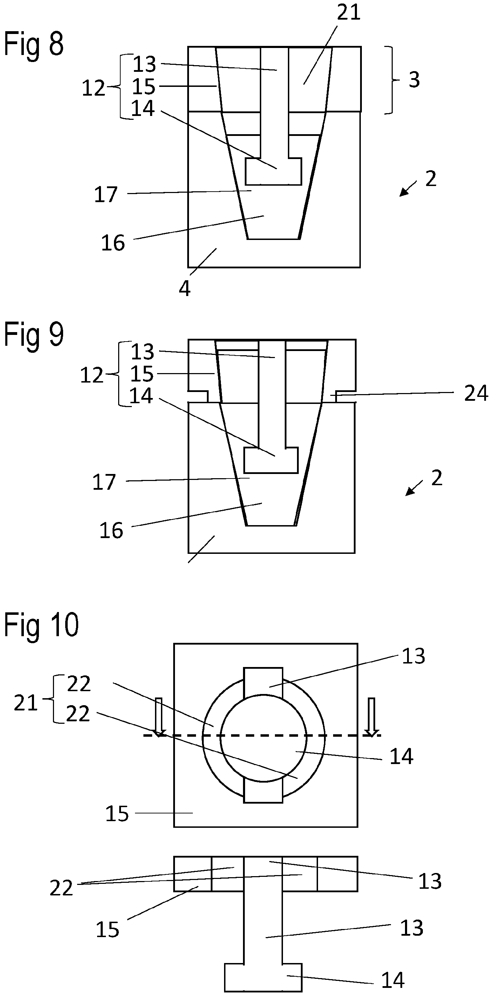

In a method stage according to Figure 8, the potting material 17 can be introduced in the recess 16 via the opening 21. After arranging the top portion 3 on the bottom portion 4, the potting material 17 is filled into the recess 16 through the opening 21, wherein a filling level of the potting material 17 is advantageously kept below the top surface of the bottom portion 4 to avoid leakage. At least the anchoring structure 14 - being a horizontal portion of the anchoring element 12 - should be completely embedded into the potting material 17. Finally, the potting material 17 is hardened e.g. by a curing process.

Alternatively, the potting material 17 can be introduced in the recess 16 before the top portion 3 is arranged on the bottom portion 4 and after the potting material 17 is introduced in the recess 16. This means that it is possible to fill the potting material 17 into the recess 16 before arranging the top portion 3 on the bottom portion 4. In this alternative case, the opening 21 would not be necessary.

In a method stage according to Figure 9, if the potting material 17 is introduced in the recess 16 through the opening 21, the potting material 17 can completely fill the recess 16 and can further be introduced in the opening 21. This means that the potting material 17 is provided in the recess 16 and at least partly in the opening 21. This also means that a higher filling degree of the potting material 17, e.g. up to the opening 21, can advantageously be achieved. In this case, an intermediate element 24 is an integral element of the top portion 3 and arranged around the opening 21 to advantageously prevent sideways leakage of the potting material 17, particularly at an interface between top portion 3 and bottom portion 4. Exemplarily, if the potting material 17 is arranged in the opening 21, the intermediate element 24 is arranged between the top portion 3 and the bottom portion 4.

Exemplarily, the method stages in Figures 6 to 9 illustrate possible method stages for producing the housing structure 2 described herein before, particularly described in Figures 1 to 3.

The anchoring elements 12 according to Figures 10 to 16 can be used in the housing structures 2 according to Figures 1 to 3. In particular, the anchoring elements 12 may have any possible shape which is suitable for a reliable fixation between the top portion 3 and the bottom portion 4. Exemplarily, any combination of the design features is possible.

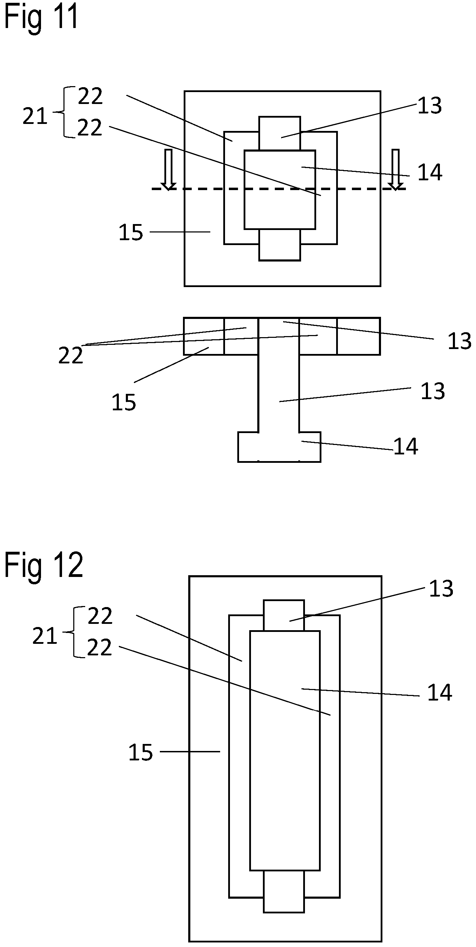

In Figures 10, 11, and 13 to 16, an upper part of the respective Figure shows a view towards the bottom surfaces, and a lower part of the respective Figure shows a side view towards side surfaces. In Figure 12, only the view towards the bottom surfaces is shown as the side view corresponds to the lower part in Figure 11.

The anchoring element 12 of Figure 10 corresponds to the anchoring element 12 according to Figures 4 and 5.

In contrast to Figure 10, the anchoring structure 14 of Figure 11 has a cross-sectional shape in lateral directions that is polygonal, in particular has a rectangular shape. Furthermore, a cross-sectional shape in lateral directions of the top main portion 15 and/or the opening 21 is polygonal, in particular has a square shape, wherein the sub-openings are shaped accordingly.

In contrast to Figure 11, the top main portion 15 and/or the opening 21 of Figure 12 has a cross-sectional shape in lateral directions that is polygonal, in particular has a rectangular shape.

In Figures 10 to 12, the anchoring structure 14 does not extend entirely along a maximal extension along the main extension direction in lateral directions of the shaft 13.

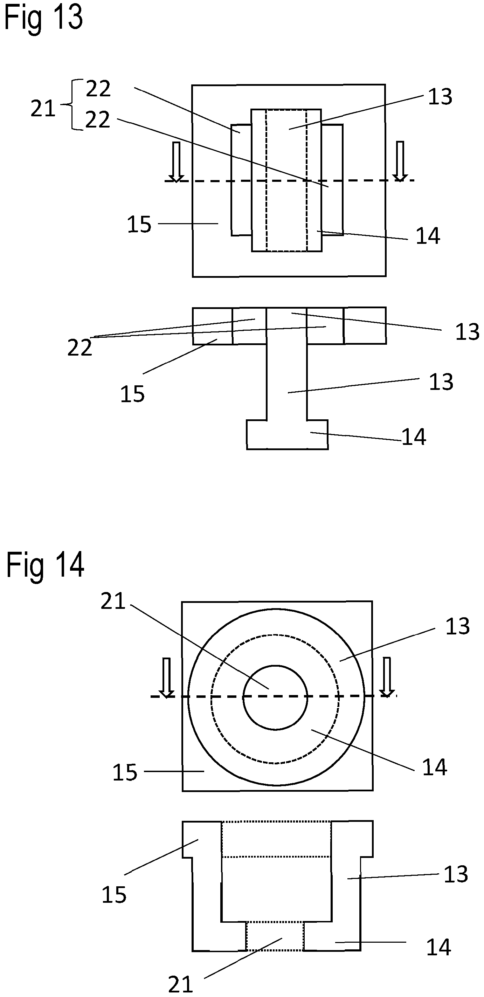

In contrast to Figure 11, the anchoring structure 14 of Figure 13 extends entirely along a maximal extension along the main extension direction in lateral directions of the shaft 13.

In Figures 10 to 13, the shaft 13 divides the opening 21 in sub-openings 22, and a cross section of the shaft 13 and the anchoring structure 14 in one lateral direction and in the vertical direction has a T-shape structure.

In contrast to Figures 10 to 13, the shaft 13 of Figure 14 has the form of a hollow extrusion. A cross section of the shaft 13 and the anchoring structure 14 in one lateral direction and in the vertical direction has an L-shape structure, particularly, a cross-section in one lateral direction and in the vertical direction has two L-shape structures. Furthermore, a cross-sectional shape in lateral directions of the opening 21 is round, in particular has a round shape.

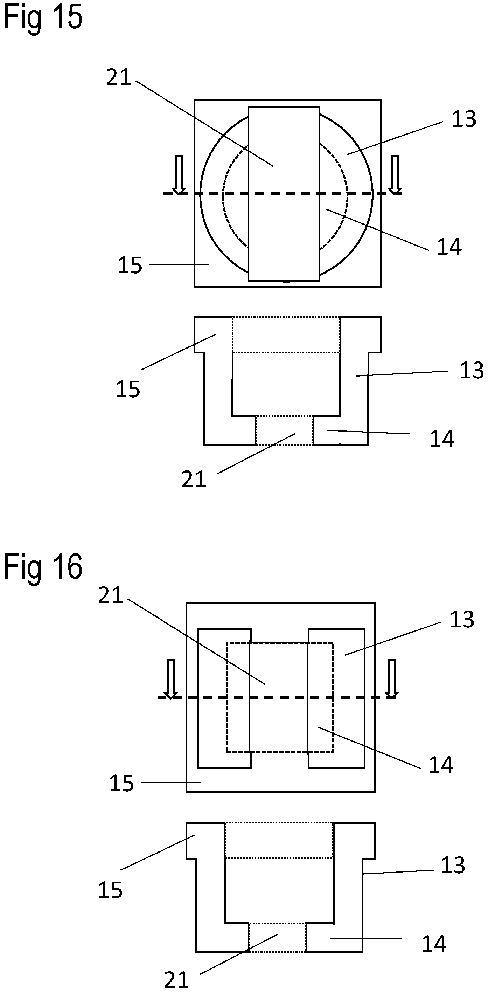

In contrast to Figure 14, a cross-sectional shape in lateral directions of the opening 21 of Figures 15 and 16 is polygonal, in particular has a polygonal shape. A cross section of the hollow extrusion of Figure 16 has, in contrast to Figures 14 and 15, a rectangular shape in lateral directions.

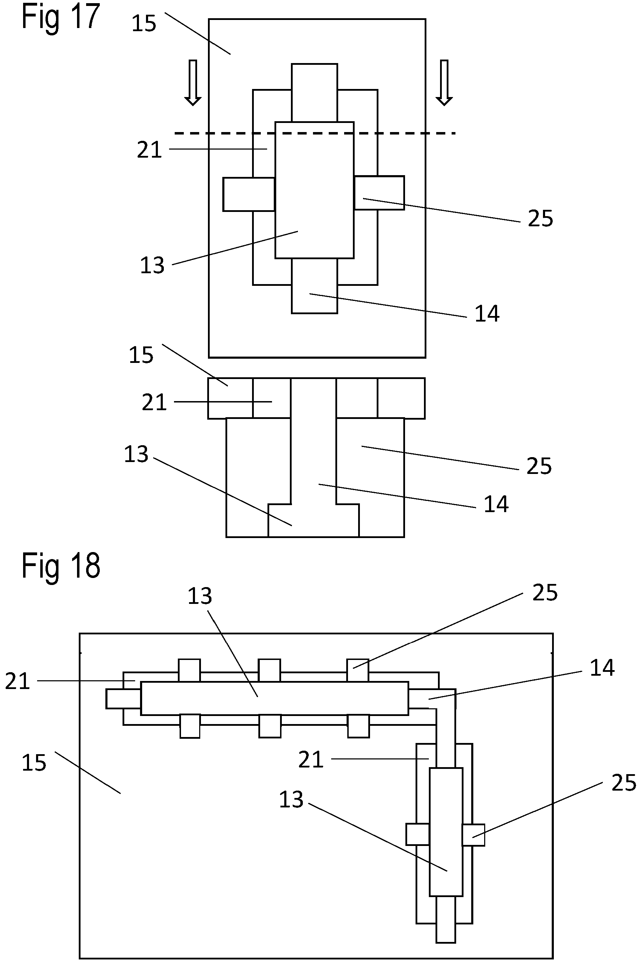

The anchoring element 12 according to Figure 17 has an additional supporting structure 25. The additional supporting structure 25 has a main extension plane being perpendicular to a main extension plane of the shaft 14. The shaft 14 and the additional supporting structure 25 can be formed integrally with one another. In particular, the additional supporting structure 25 connects shaft 13 with top main portion 3.

The anchoring element 12 according to Figure 18 has multiple openings 21, and anchoring structures 13, as well as multiple additional supporting structures 25. The openings 21 and corresponding anchoring structures 13 are included in one top main portion 15. The sub-openings 22 are now defined by the shafts 13, but also by the additional supporting structures 25.

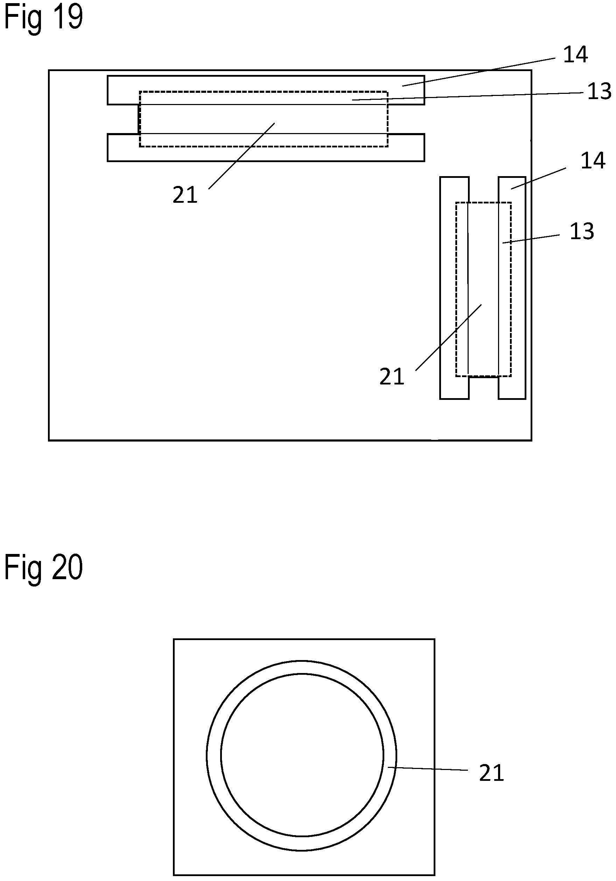

The anchoring element 12 according to Figure 19 has multiple openings 21, and anchoring structures 13, as well as shafts 14.

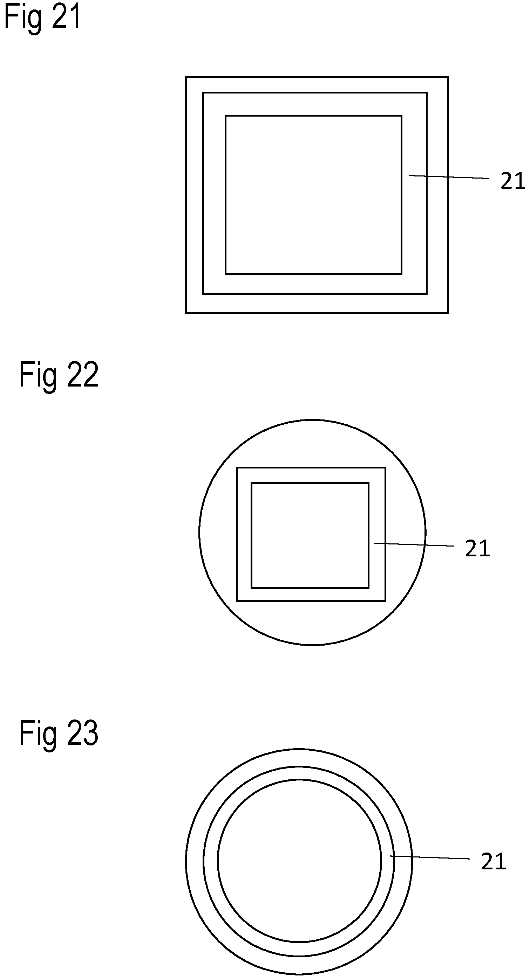

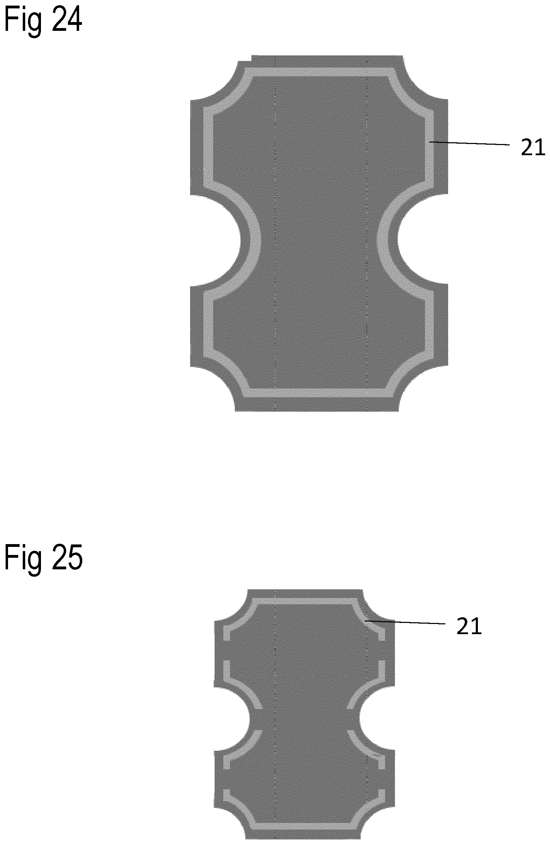

The anchoring elements 12 according to Figures 20 to 25 have continuous groove openings 21. The groove opening 21 could have any shape. Further the respective anchoring structures 13 can be also formed continuously extending along the groove openings 21.

The exemplary embodiments and the embodiments described above, in particular the features of the exemplary embodiment and the embodiments, of the figures and of the specification may be combined with one another.

### Reference Signs

- 1: power semiconductor module
- 2: housing structure
- 3: top portion
- 4: bottom portion
- 5: peripheral region
- 6: mounting portion
- 7: top metallization
- 8: insulation substrate sheet
- 9: bottom metallization
- 10: housing cavity
- 11: further top main portion
- 12: anchoring element
- 13: shaft
- 14: anchoring structure
- 15: top main portion
- 16: recess
- 17: potting material
- 18: cooler or baseplate
- 19: terminal assembly
- 20: terminal
- 21: opening
- 22: sub-opening
- 24: intermediate element
- 25: additional supporting structure

## Claims

1. Housing structure (2) for a power semiconductor module (1) with at least one power semiconductor chip arranged on a mounting portion (6), comprising
- a bottom portion (4) configured to surround the at least one power semiconductor chip arranged on the mounting portion (6) in lateral directions, and
- a top portion (3) arranged on the bottom portion (4), wherein
- the top portion (3) comprises at least one anchoring element (12) comprising
- at least one shaft (13) having a main extension direction in a vertical direction, and
- at least one anchoring structure (14) having a main extension direction in lateral directions arranged at the at least one shaft (13),
- the bottom portion (4) comprises at least one recess (16),
- the at least one shaft (13) is arranged at least partially, and the at least one anchoring structure (14) is arranged completely, in the at least one recess (16), and
- a potting material (17) is at least partially arranged in the at least one recess (16).

2. Housing structure (2) according to claim 1, wherein
- the at least one recess (16) partially penetrates the bottom portion (4) in a vertical direction.

3. Housing structure (2) according to claim 1 or 2, wherein
- the at least one anchoring element (12) comprises a top main portion (15) having a main extension direction in lateral directions, and
- the at least one shaft (13) is arranged on the top main portion (15).

4. Housing structure (2) according to any one of claims 1 to 3, wherein
- the top main portion (15) has at least one opening (21), and
- the opening (21) completely penetrates the top main portion (15) in the vertical direction.

5. Housing structure (2) according to claim 4, wherein
- the potting material (17) is completely arranged in the at least one recess (16), and
- the potting material (17) is at least partially arranged in the opening (21).

6. Housing structure (2) according to any one of claims 1 to 5, wherein
- a cross-sectional shape in lateral directions of the at least one shaft (13) is round, elliptic, or polygonal.

7. Housing structure (2) according to any one of claims 1 to 6, wherein
- a cross-sectional shape in lateral directions of the at least one anchoring structure (14) is round, elliptic, or polygonal.

8. Housing structure (2) according to any one of claims 1 to 7, wherein
- the potting material (17) comprises or consists of a glue and/or a resin.

9. Housing structure (2) according to any one of claims 1 to 8, wherein
- the top portion (3) comprises a further top main portion (11), and
- the top main portion (15) of the at least one anchoring element (12) and the further top main portion (11) are connected in a mechanically stable manner.

10. Housing structure (2) according to any one of claims 1 to 9, wherein
- the bottom portion (4) is a frame or a molded package, and/or
- the top portion (3) is a cover or a terminal assembly (19).

11. Housing structure (2) according to claim 9, wherein
- the terminal assembly (19) comprises at least one terminal (20) having a main extension direction in the vertical direction.

12. Power semiconductor module (1), comprising
- at least one mounting portion (6),
- at least one power semiconductor chip arranged on the mounting portion (6), and
- the housing structure (2) according to any one of claims 1 to 11, wherein
- the housing structure (2) and the mounting portion (6) enclose the at least one power semiconductor chip.

13. Method for producing a housing structure (2), comprising:
- providing a bottom portion (4) configured to surround at least one power semiconductor chip arranged on a mounting portion (6) in lateral directions, wherein the bottom portion (4) comprises at least one recess (16), and
- providing a top portion (3) comprising at least one anchoring element (12) comprising
- at least one shaft (13) having a main extension direction in a vertical direction, and
- at least one anchoring structure (14) having a main extension direction in lateral directions and being arranged at the at least one shaft (13),
- arranging the top portion (3) on the bottom portion (4) such that
- the at least one shaft (13) is arranged at least partially, and the at least one anchoring structure (14) is arranged completely, in the at least one recess (16), and
- a potting material (17) is at least partially arranged in the at least one recess (16).

14. Method according to claim 13, further comprising:
- filling the potting material (17) in the at least one recess (16) before the top portion (3) is arranged on the bottom portion (4).

15. Method according to claim 13, further comprising:
- filling the potting material (17) in the at least one recess (16) through at least one opening (21) of a top main portion (15) of the at least one anchoring element (12) after the top portion (3) is arranged on the portion (4).

## Amended claims

### Amended claims in accordance with Rule 137(2) EPC.

1. Housing structure (2) for a power semiconductor module (1) with at least one power semiconductor chip arranged on a mounting portion (6), comprising
- a bottom portion (4) configured to surround the at least one power semiconductor chip arranged on the mounting portion (6) in lateral directions, and
- a top portion (3) arranged on the bottom portion (4), wherein
- the top portion (3) comprises at least one anchoring element (12) comprising
- at least one shaft (13) having a main extension direction in a vertical direction, and
- at least one anchoring structure (14) having a main extension direction in lateral directions arranged at the at least one shaft (13),
- the bottom portion (4) comprises at least one recess (16),
- the at least one shaft (13) is arranged at least partially, and the at least one anchoring structure (14) is arranged completely, in the at least one recess (16),
- a potting material (17) is at least partially arranged in the at least one recess (16), and
- the at least one anchoring structure (14) is embedded in the potting material (17).

2. Housing structure (2) according to claim 1, wherein
- the at least one recess (16) partially penetrates the bottom portion (4) in a vertical direction.

3. Housing structure (2) according to claim 1 or 2, wherein
- the at least one anchoring element (12) comprises a top main portion (15) having a main extension direction in lateral directions, and
- the at least one shaft (13) is arranged on the top main portion (15).

4. Housing structure (2) according to claim 3, wherein
- the top main portion (15) has at least one opening (21), and
- the opening (21) completely penetrates the top main portion (15) in the vertical direction.

5. Housing structure (2) according to claim 4, wherein
- the potting material (17) is completely arranged in the at least one recess (16), and
- the potting material (17) is at least partially arranged in the opening (21).

6. Housing structure (2) according to any one of claims 1 to 5, wherein
- a cross-sectional shape in lateral directions of the at least one shaft (13) is round, elliptic, or polygonal.

7. Housing structure (2) according to any one of claims 1 to 6, wherein
- a cross-sectional shape in lateral directions of the at least one anchoring structure (14) is round, elliptic, or polygonal.

8. Housing structure (2) according to any one of claims 1 to 7, wherein
- the potting material (17) comprises or consists of a glue and/or a resin.

9. Housing structure (2) according to any one of claims 1 to 8, wherein
- the top portion (3) comprises a further top main portion (11), and
- the top main portion (15) of the at least one anchoring element (12) and the further top main portion (11) are connected in a mechanically stable manner.

10. Housing structure (2) according to any one of claims 1 to 9, wherein
- the bottom portion (4) is a frame or a molded package, and/or
- the top portion (3) is a cover or a terminal assembly (19).

11. Housing structure (2) according to claim 10, wherein
- the terminal assembly (19) comprises at least one terminal (20) having a main extension direction in the vertical direction.

12. Power semiconductor module (1), comprising
- at least one mounting portion (6),
- at least one power semiconductor chip arranged on the mounting portion (6), and
- the housing structure (2) according to any one of claims 1 to 11, wherein
- the housing structure (2) and the mounting portion (6) enclose the at least one power semiconductor chip.

13. Method for producing a housing structure (2), comprising:
- providing a bottom portion (4) configured to surround at least one power semiconductor chip arranged on a mounting portion (6) in lateral directions, wherein the bottom portion (4) comprises at least one recess (16), and
- providing a top portion (3) comprising at least one anchoring element (12) comprising
- at least one shaft (13) having a main extension direction in a vertical direction, and
- at least one anchoring structure (14) having a main extension direction in lateral directions and being arranged at the at least one shaft (13),
- arranging the top portion (3) on the bottom portion (4) such that
- the at least one shaft (13) is arranged at least partially, and the at least one anchoring structure (14) is arranged completely, in the at least one recess (16), and
- a potting material (17) is at least partially arranged in the at least one recess (16), wherein
- the at least one anchoring structure (14) is embedded in the potting material (17).

14. Method according to claim 13, further comprising:
- filling the potting material (17) in the at least one recess (16) before the top portion (3) is arranged on the bottom portion (4).

15. Method according to claim 13, further comprising:
- filling the potting material (17) in the at least one recess (16) through at least one opening (21) of a top main portion (15) of the at least one anchoring element (12) after the top portion (3) is arranged on the portion (4).
